(19) Europäisches Patentamt
European Patent Office
Office européen des brevets

(11) Publication number: **0 097 282**
A2

(12) # EUROPEAN PATENT APPLICATION

(21) Application number: 83105619.7

(51) Int. Cl.³: G 03 F 7/26

(22) Date of filing: 08.06.83

(30) Priority: 17.06.82 US 389276
15.04.83 US 485409

(43) Date of publication of application:
04.01.84 Bulletin 84/1

(84) Designated Contracting States:
BE DE FR GB IT NL SE

(71) Applicant: SHIPLEY COMPANY INC.
2300 Washington Street
Newton, Massachusetts 02162(US)

(72) Inventor: Cawston, John D.
3 Indian Hill Road
Winchester, Massachusetts 01890(US)

(72) Inventor: Becker, Paul E., Jr.
22 Revere Street
Canton, Massachusetts 02021(US)

(74) Representative: Leiser, Gottfried, Dipl.-Ing. et al,
Patentanwälte Prinz, Bunke & Partner Ernsberger Strasse 19
D-8000 München 60(DE)

(54) **Developer compositions for photoresists.**

(57) An aqueous metal ion containing developer composition for developing photoresists comprising a metal ion-free alkali and a metal ion-free surfactant that is a quaternary ammonium compound. The developer permits a reduction of from 20 to 50% in the energy necessary to expose the photoresist without deleterious effect on image quality and image resolution.

EP 0 097 282 A2

European Patent Application
No. 83105619.7 August 9, 1983
SHIPLEY COMPANY INC.

Our File: S 3152

# DEVELOPER COMPOSITION FOR PHOTORESISTS

## Cross Reference to Related Applications

This is a continuation-in-part application of copending U.S. Patent Application Serial No. 389,276 filed June 17, 1982 and U.S. Patent Application Serial No. 485,409 filed April 15, 1983, said latter application being a continuation-in-part of U.S. Patent Application Serial No. 252,915 filed April 10, 1981.

## Introduction

This invention relates to developer compositions for photoresists, and more particularly, to novel high speed developer compositions containing one or more quaternary ammonium surfactants of the type disclosed herein and one or more metal ion alkali compounds.

## Background of the Invention

In the manufacture of integrated circuit devices, printed circuit boards, printing plates and in related arts, resist processes are used whereby images are formed on a substrate to protect selected portions of the substrate during subsequent manufacturing processes, such as, for example, etching, metal deposition and diffusion processes. The resist processes employ radiation sensitive organic compositions which are coated onto the substrate surface and then exposed patternwise to light or other suitable actinic radiation such as, for

example, x-rays, gamma rays or an electron beam. The exposed resist layer is then developed by methods known in the art and the portions of the substrate which are bared by development can then be treated.

Both positive and negative working photoresists are known. A positive resist is composed typically of a base soluble binder such as phenol formaldehyde novolak or polyvinyl phenol resins and a sensitizer, that is, a photoactive compound, such as a diazo compound. Such sensitizers and resists are described, for example, in U.S. Patents Nos. 3,046,118; 3,046,121; 3,106,465; 3,201,239; 3,666,473; 4,009,033 and 4,093,451, incorporated herein by reference.

In copending U.S. Patent Application Serial No. 485,409 filed April 15, 1983, assigned to the same assignee as the subject application and incorporated herein by reference, there is disclosed a new developer composition for positive working photoresists. The developer comprises a metal ion free source of alkali in combination with a specific class of quaternary ammonium surfactants. The developer eliminates metal ions from the formulation which is desirable in the manufacture of integrated circuits. The developer also provides a faster rate of development yielding a developed image having excellent image resolution and quality.

The above-described metal ion free developers are more expensive than conventional developers in that the metal ion free source of alkalinity is more costly than a metal alkali such as sodium or potassium hydroxide. The added expense makes the use of the developer for the manufacture of printed circuit boards and other related uses unattractive since metal ion contamination is not a problem in such manufacture and the added cost is not justified. Therefore, it is desirable to provide a developer formulation possessing the properties of the above-described developer

that is lower in cost to make, use and waste treat.

Summary of the Invention

The present invention is directed to a developer particularly useful for the development of photoresists used in the manufacture of printed circuit boards, chemical milling and other applications where metal ion contamination is not a problem. The developer comprises that quaternary ammonium surfactant described in the above-identified patent application with a metal ion containing alkali. The developer possesses the advantages of the metal ion free developer in that its use provides improved resist images, especially improved resist edge acuity, and improved speed.

In addition to the above, the developers of the invention possess the additional advantages of:

1. lower material costs;
2. applicability in printed circuit applications because of lower cost; and
3. simplified waste disposal.

Detailed Description

The present invention provides a novel aqueous alkaline developer for the development of alkali developable photoresists. It operates preferably at a temperature of approximately 10° to 30°C, more preferably at about 20°C or room temperature.

The developer composition of the invention can be used in any manner suitable for known developers. Thus, immersion, spray, and puddle techniques can be used. The photoresist to be developed is generally applied to a substrate, image-wise exposed to actinic radiation and subsequently contacted with the developer. Development of the photomechanical image typically requires about 60 seconds if by immersion, less if by spray or puddle techniques. Subsequent to development, the work piece can then be rinsed and further processed as desired.

Metal ion-containing compounds suitable for use in the novel developer composition of the invention are water soluble and must provide the necessary alkalinity. The novel developer composition of the invention is operative at a pH between about 11 to 14, but most preferably operative between about 12.5 and 13. Below about pH 11, there is a significant decrease in the speed of development.

The alkali component of the developer of the present invention is any of those known to those skilled in the art for use in photoresist developers. Suitable alkali compounds include, for example, alkali metal hydroxides such as caustic soda (sodium hydroxide), which is generally preferred, or potassium hydroxide. Also suitable, for example, are the alkali metal phosphates such as mono-, di- or tri-basic sodium phosphate and the alkali metal borates, e.g., sodium borate, and alkali metal silicates such as sodium metasilicate.

The surfactant of the developer composition of the invention comprises one or preferably, a mixture of quaternary ammonium compounds, where each corresponds to the general formula:

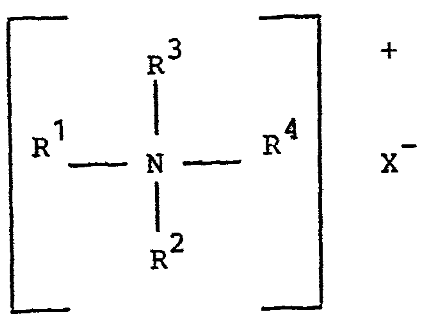

(I)

wherein

$R^1$ comprises a saturated or unsaturated, straight or branched hydrocarbon chain having from 6 to 20 carbons, and from 0 to 3 oxygens, provided that each oxygen can be separated from others by at least one carbon, and which is alkoxy substituted or unsubstituted;

$R^2$ and $R^3$ are the same or different and each comprises alkyl of from 1 to 3 carbons; or $(R^5O)_nH$ wherein $R^5$ is alkylene of 1 to 3 carbons and n is an integer of from 1 to 20; or $R^2$ and $R^3$ together comprise a cycloaliphatic hydrocarbon of from 2 to 8 carbons with from 0 to 2 heteroatoms selected from O, N, and S, provided that each heteroatom be separated from another and from the quaternary nitrogen by at least one carbon; or $R^2$ and $R^3$ together comprise a cycloaromatic hydrocarbon of from 2 to 8 carbons with from 0 to 2 nitrogen heteroatoms, provided that each nitrogen atom be separated from another and from the quaternary nitrogen by at least one carbon;

$R^4$ comprises a saturated or unsaturated, straight or branched hydrocarbon having from 1 to 10 carbon atoms; $(R^5O)_nH$ as defined above; phenylalkyl, wherein the alkyl moiety has from 0 to 3 carbons; or

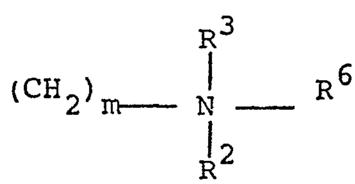

wherein m is from 1 to 4, $R^2$ and $R^3$ are as defined above, and $R^6$ is saturated or unsaturated, straight or branched hydrocarbon having from 1 to 10 carbon atoms; or $(R^5O)_nH$ as defined above; or phenylalkyl having an alkyl group of from 0 to 3 carbon atoms; and

X comprises halo, hydroxy, or silicate, or the corresponding amino acids of said quaternary ammonium compounds.

Preferably, there are in $R^2$, $R^3$ and $R^4$, in total, no more than 15 alkoxy units, $(R^5O)$, most preferably, no more than 2.

Preferred for use in the invention are quaternary ammonium compounds having the general formula II:

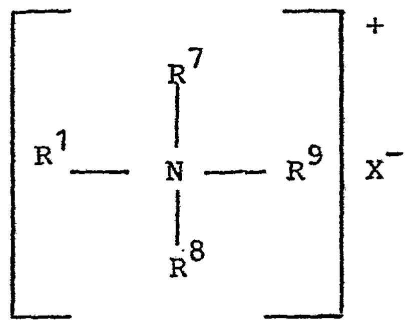

(II)

wherein

$R^1$ and X are defined for Formula I;

$R^7$ and $R^8$ are the same or different and each comprises alkyl of from 1 to 3 carbons; or $(R^5O)_nH$ wherein n is 1 and $R^5$ is as defined for Formula I; and

$R^9$ comprises a saturated or unsaturated, straight, branched or cyclic hydrocarbon having from 1 to 10 carbons; $(R^5O)_nH$ wherein n is 1 and $R^5$ is defined for Formula I; phenylalkyl wherein the alkyl moiety has from 0 to 3 carbons; or

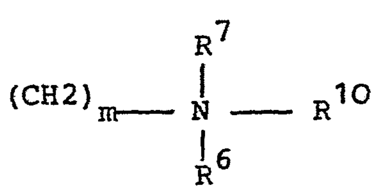

(III)

wherein

m is from 1 to 4, $R^6$ and $R^7$ are as defined above, and $R^{10}$ is saturated or unsaturated, straight or branched hydrocarbon having from 1 to 10 carbon atoms; or $(R^5O)_nH$ as defined above; or phenalkyl having an alkyl group of

from 0 to 3 carbon atoms.

Developers according to the invention, comprising one or more surfactants as described above, have been found more selective in developing exposed areas of photoresist, and to have little or no attack on the unexposed photoresist. A metal ion containing developer, made according to the invention, markedly reduces the required exposure time to create the required image by at least 20% and frequently, from 40 to 50% and thus, increases board throughout.

By comparison, using known developers, a reduction of exposure time by 40 to 50% cannot be achieved even by using a bath of increased concentration, because of attack on the unexposed photoresist. Thus, known developers show much less selectivity between exposed and unexposed areas.

Among the preferred surfactants are those comprising ethoxylated quaternary ammonium compounds having the general formula:

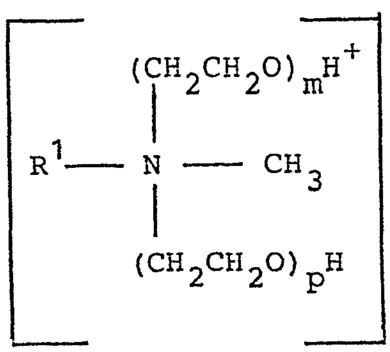 $X^-$ (IV)

wherein

m and p are each 1 or 2 and $R^1$ is alkyl of from 8 to 18 carbon atoms in approximately the following proportions:

TABLE 1

| $R^1$ carbon chain length | % |
|---|---|
| $C_8$ | 5 |
| $C_{10}$ | 6 |
| $C_{12}$ | 51 |
| $C_{14}$ | 19 |
| $C_{16}$ | 9 |
| $C_{18}$ | 5 |

Most preferably, such surfactants comprise ethoxylated quaternary ammonium compounds wherein m and p are each 1, that is, methylbis-(2-hydroxyethyl)cocoammonium chloride. Such surfactants can be derived from coconut oil, and one such is commercially available under the trademark "ETHOQUAD C/12" (Armak Co., Pasadena, Texas, sold as a 75% active solution).

Also preferred are the compounds of the Formula I wherein $R^2$, $R^3$ and $R^4$ are alkyl of 1 to 3 carbon atoms, most preferably methyl, and $R^1$ is as defined in Formula IV. Most preferred of such surfactants is trimethylcocoammonium chloride, which surfactant can be derived from coconut oil and is commercially available under the trademark "ARQUAD C-50" (Armak Co., Pasadena, Texas, sold as a 50% active solution).

Another preferred surfactant comprises a mixture of two compounds, one conforming to Formula IV where $R^1$ has 12 carbon atoms and m and p total 15 and the second wherein $R^1$ is 90% $C_{18}$ and 10% $C_{16}$. This surfactant is available under the trademark "ETHOQUAD 18/25" (Armak Co., Pasadena, Texas, sold as a 90% active solution).

The amount of surfactant employed in the developer composition of the invention will depend in part upon the quaternary ammonium compound(s) chosen and the particular application for which it is used, but is generally used in an amount sufficient to reduce the exposure energy by at least 20% compared to a developer free of said surfactant. Thus, for example, if the surfactant comprises ETHOQUAD C/12, described above, and the alkali is sodium hydroxide, the total amount used is from 0.02 to 45 grams of active C/12 per liter of developer, and more preferably, from about 0.1 to 7.5 grams of active C/12 per liter. In one most preferred embodiment, from about 0.2 to 10 grams of active ETHOQUAD C/12 is used in conjunction with from about 1 to 4 grams of active ETHOQUAD 18/25 per liter.

The quaternary ammonium compounds which comprise the surfactant of the developer compositions can be readily prepared according to methods well known to those skilled in the art. Alternatively, many suitable compounds, or preferably, mixtures of compounds, are readily commercially available.

While not intending to be bound by theory, it is believed that the newly discovered efficacy of the compounds of Formula I results from their ability to reduce the surface tension of the developer bath at the interface with the photoresist. Thus, there is improved wetting of the exposed photoresist with the developer continuously through the development of the photo image. In this way, the alkali of the developer has better contact and thus, more effective action on the acids of the exposed portions of the resist.

It is theorized that such ability to reduce surface tension stems in large part from the affinity of the hydrophobic $R^1$ moiety of the surfactant for the polymeric resin of the photoresist. In this regard, it is further theorized that surfactants comprising a mixture of such compounds, wherein the length of $R^1$ carbon chain varies, are especially

efficatious because the resin system typically also comprises carbon chains of varied length. For example, in the case of a novolak resin, there are different novolak resin structures. Thus, different $R^1$ chain lengths provide the greatest affinity and hence, the greatest wetting action for each of those different structures. Thus, a synergistic effect is achieved through the combined action of the different length $R^1$ carbon chains.

In addition to the alkali and surfactant described above, the developer composition of the invention may further comprise one or more suitable polyhydric compounds. Suitable polyhydric compounds for use in aqueous alkaline developers are known to the skilled in the art and include glycerol, ethylene glycol and polyglycols and glycol ethers. Glycerol is preferred. Amounts up to about 60 grams per liter of glycerol have been found to be particularly suitable. Preferably, an amount of about 25 to 30 grams per liter is used.

The present invention provides a novel alkali metal containing high speed developer suitable for development of positive type photoresists and those negative photoresists that are alkali soluble. It is believed to be suitable for etching polyamide films in two-layer processing. It is particularly effective for development of positive photoresist containing diazo-type sensitizers, such as 1-oxo-2-diazo-naphthalene-5-sulfonate ester in a novolak or polyvinyl phenol system. Such positive-type photoresists include, for example, the Micorposit$^R$ 1300 and 1400 series of photoresists marketed by Shipley Company Inc. of Newton, Massachusetts. The developer composition of the invention is also highly effective for development of such photoresists containing different sensitizers, for example, 1-oxo-2-diazo-naphthalene-4-sulfonate ester or other photoactive materials known to the skilled in the art.

The developer dissolves those portions of the photoresists that have been exposed to actinic radiation with improved selectivity. That is, even when the amount of exposure energy is reduced, the developer composition of the invention will dissolve the exposed portion(s) with less attack on the unexposed portion(s) than known developers. Thus, better image resolution and quality is provided while the rate of production is increased due to the reduced exposure time.

The developer composition of the invention can comprise components in addition to those described above. Such other components include, for example, dyes, additional wetting agents, buffers, and others known to those skilled in the art.

The novel developer of the invention can be made according to methods known in the art, which methods comprise mixing the components in any suitable manner to achieve homogeneous distribution. It is preferred to start with the alkali component and to mix the buffer, if any, quaternary ammonium, surfactant(s) and polyhydric compound, if any.

In addition to the above, the developer will develop lesser exposed photoresist without significant loss of selectivity, that is, the ability to discriminate between exposed and unexposed portions of the resist, and to dissolve the former without significant attack on the unexposed portions. Accordingly, given a source of actinic radiation of certain intensity, resist-coated substrates can be image-wise exposed to sufficient radiation in a shorter period of time when the resulting latent image-bearing photoresist is to be developed by the developer of the present invention. Consequently, especially where image-wise exposure is a limiting step in the manufacturing process, the rate of production can be significantly increased through use of this invention.

Another advantage provided by the novel developer composition of the invention is improved resolution of the developed image. In the past, attempts have been made to improve image resolution by employing known developers at reduced concentrations. However, this requires longer development time, which can cause undercutting of the resist at the edges of the image. The result is inaccurate and inadequate protection of the substrate. In contrast, the novel developer composition of the invention provides improved resolution over a wide concentration range without significant undercutting.

Developer compositions, according to the invention are employed for the development of photoresists according to the same methods and techniques employed for prior art developers. Photoresist is exposed through a conventional light source under conventional conditions and the exposed photoresist layer is then contacted with the developer composition of the invention for a suitable period of time by immersion, spray or puddle techniques.

A significant advantage is provided in forming an image that is developed with the developer of the invention. The resist-coated substrate may be exposed to less actinic radiation than is normally required. That is, the developer of the invention will develop the image when the resist has been exposed to less actinic radiation than is usually required for good results, though alternatively, conventional exposure conditions can be used with a shorter development time.

Another significant advantage of the present developer is the ability to tolerate higher concentration. That is, even when used at higher concentration, the present developer composition selectively dissolves the exposed portion of the photoresist with little or no attack on the unexposed portions. By comparison, the use of known developers at

higher concentration generally results in significant loss of selectivity and thus, poor resolution of the resist image. For this reason, they must be used at lower concentration for a longer development period. As stated above, however, such longer development period is known to cause undercutting of the developed resist image, which results in distortion of the photoresist image with well known adverse consequences in the quality of the substrate following subsequent treatment steps. By operating with greater selectivity at greater concentration, the developer of the invention provides better resolution without undercutting the resist image while providing reduced development time.

A most significant advantage of the novel developer of the invention is that the developing conditions are virtually constant over the life of the bath. The development speed, and the processing conditions, most notably exposure time and development time, will remain virtually constant. In contrast, the efficacy and speed of known developers change during the initial use of the developer bath. Thus, taking printed circuit board manufacture as an example, it is typical according to present methods to adjust the exposure time by trial and error for the first processed boards. Since the necessary development time is not constant, but rather decreases during such initial use, boards are often over-developed, and the entire process must be monitored constantly. This results in significant loss of boards and considerable additional cost.

The following examples will better illustrate developers of the invention.

EXAMPLE 1

A developer composition according to the most preferred embodiment of the invention was made by mixing the following in the order given:

| | |
|---|---|
| Glycerol | 511 grams |
| NaOH | 400 grams |
| Boric acid | 227 grams |
| ETHOQUAD C/12 | 0.8 grams |
| ETHOQUAD 18/25 | 1.0 grams |
| Water | to make 9 liters |

A clear colorless solution was obtained at a normality of 0.5N.

The speed and selectivity of the instant developer composition was compared to that of known developers. Silicon wafers, each of 3 inches diameter, were coated with AZ 1470 photoresist (Shipley Company, Inc., Newton, Massachusetts) at a thickness of 1.4/u. The coated wafers were exposed with 60 millijoules $cm^{-2}$ energy from an actinic radiation source through a graduated density stepfilter. The wafers, 3 each, were immersion developed for 20 seconds in 1 of 4 developer solutions and immersion rinsed in deionized water for 60 seconds and then blown dry with $N_2$. The first 3 solutions were separate batches of developer solution made according to Example 1, diluted to 0.12N. The fourth bath was Microposit Developer 351S (Shipley Company, Newton, MA) prepared by mixing 1 part developer with 3-1/2 parts of deionized water, (0.089N), and used according to directions. All solutions were used at 22.5°C. Following development the resist layers were again measured for thickness to determine selectivity, that is, the amount of loss of unexposed resist, and then visually examined to determine the percent transmission needed for complete development. The results are tabulated below:

TABLE I

| Developer Solution | Energy Transmitted for Step Clearance. Identical | Resist.Thickness Loss (A) |
|---|---|---|
| Batch 1 | 22.5 | 300 |
| " | " | 320 |
| " | " | 315 |
| | | Avg. 311.67 |
| Batch 2 | 22.5 | 381 |
| " | " | 296 |
| " | " | 302 |
| | | Avg. 362.33 |
| Batch 3 | 22.5 | 341 |
| " | " | 326 |
| " | " | 300 |
| | | Avg. 322.33 |
| Micropost 351S | 35.0 | 670 |
| " | " | 620 |
| " | " | 580 |
| | | Avg. 623.33 |

The results for the three batches of developer are consistent within experimental error. The test results show that the metal ion developer is approximately 35.7% faster, that is, requires 35.7% less exposure energy than the Microposit 351S developer used as a control.

Moreover, regarding selectivity, visual examination of the wafers under a microscope revealed that each batch of the

developer of the invention had virtually no effect on the photoresist receiving less than approximately 18 to 20% transmission. Thus, unless having received at least about 18% transmission and being developed completely, the photoresist was unattacked by the developer. By comparison, photoresist developed with Microposit 351S which received less than the 35.0 transmission needed for complete development, over a broad range down to 5% was attacked by the developer to a significant extent.

EXAMPLE 3

sodium silicate.................10.00 gm
ETHOQUAD C/12................... 0.04 gm
potassium hydroxide.............15.00 gm
water...........................to make 1 litre.

A clear, colorless solution was obtained and the normality of the solution was approximately 0.28 - 0.32 N. This developer, made diluted for use, can be used in a manner equivalent to the developer of Example 1.

CLAIMS

1. An aqueous metal ion containing developer composition comprising one or more metal ion alkali compounds and one or more quaternary surfactant compounds having the formula:

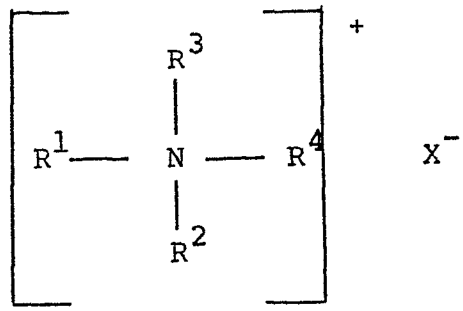

wherein

$R^1$ comprises a saturated or unsaturated, straight or branched hydrocarbon chain having from 6 to 20 carbons and from 0 to 3 oxygens, provided that each oxygen is separated from another by at least one carbon atom and optionally, said chain being substituted with one or more alkoxy groups wherein each alkoxy group has from 1 to 5 carbons;

$R^2$ and $R^3$ are the same or different and each comprises alkyl of from 1 to 3 carbons or $(R^5O)_nH$, wherein $R^5$ is alkylene of from 1 to 3 carbons and n is an integer of from 1 to 20; or

$R^2$ and $R^3$ together comprise cycloaliphatic hydrocarbon of from 2 to 8 carbons with from 0 to 2 heteroatoms selected from O, N and S, provided that each heteroatom is separated from another and from the quaternary nitrogen by at least one carbon; or

$R^2$ and $R^3$ together comprise a cycloaromatic hydrocarbon of from 2 to 8 carbons with from 0 to 2 nitrogen heteroatoms, provided that each nitrogen atom is separated from another and from the quaternary nitrogen by

at least one carbon;

$R^4$ comprises a saturated or unsaturated, straight or branched chain hydrocarbon having from 1 to 10 carbon atoms, $(R^5O)_nH$ as defined above; phenalkyl, wherein the alkyl moiety has from 0 to 3 carbons; or

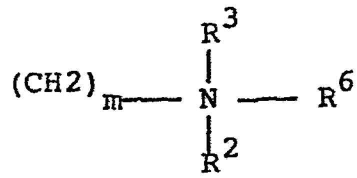

wherein m is an integer of from 1 to 4, $R^2$ and $R^3$ are as defined above, and $R^6$ is a saturated or unsaturated, straight or branched chain hydrocarbon having from 1 to 10 carbon atoms, or $(R^5O)_nH$ as defined above, or phenalkyl, having an alkyl group of from 0 to 3 carbon atoms; and

X comprises halo, hydroxy, or silicate, or the corresponding amino oxide of said quaternary ammonium compound;

said alkali compound and surfactant being present in an amount sufficient to provide effective development of an imaged photoresist.

2. The composition of Claim 1 wherein the alkali compound is an alkali hydroxide, a borate, a phosphate or a silicate of the alkali and alkaline earth metals.

3. A method of developing an exposed positive working diazo-type photoresist composition comprising contacting said photoresist composition with an amount of the composition of Claim 1 or 2 sufficient to effect development of said exposed photoresist.

4. An aqueous developer composition comprising one or more

metal ion alkali compounds and one or more surfactants of the formula:

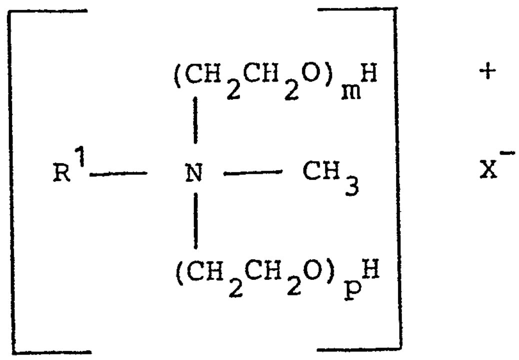

wherein $R^1$ is alkyl of from 8 to 18 carbon atoms in approximately the following proportions:

| $R^1$ carbon chain length | % |
|---|---|
| $C_8$ | 5 |
| $C_{10}$ | 6 |
| $C_{12}$ | 51 |
| $C_{14}$ | 19 |
| $C_{16}$ | 9 |
| $C_{18}$ | 5 |

and X is halo, oxide, hydroxide or silicate, m and p are each an integer from 1 to 20, said alkali compound and surfactant being present in an amount sufficient to provide effective development of an imaged photoresist.

5. The composition of Claim 4 in which X is chloride and m and p are 1.

6. The composition of Claim 5 in which there are a plurality of different cations present, the cations principally being those in which $R^1$ is $C_{12}$ to $C_{14}$.

7. A method of developing an exposed positive working diazo-type photoresist composition comprising contacting said photoresist with the composition of Claim 4, 5 or 6 in an amount sufficient to develop said exposed portions.

8. An aqueous developer composition comprising one or more metal ion alkali compounds and one or more surfactants of the formula:

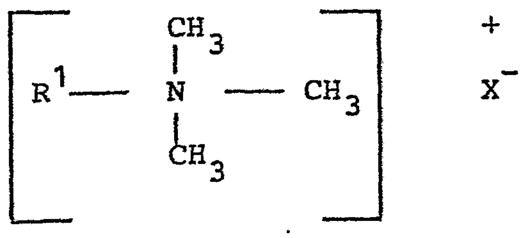

wherein $R^1$ is alkyl of 8 to 18 carbon atoms and X is halo, oxide, hydroxide or silicate, m and p are an integer from 1 to 20, said alkali compound and surfactant being present in an amount sufficient to provide effective development of an imaged photoresist.

9. The composition of Claim 8 in which X is chloride and m and p are 1.

10. The composition of Claim 9 in which there are a plurality of different cations present, the cations principally being those in which $R^1$ is $C_{12}$ to $C_{14}$.

11. A method of developing an exposed positive working diazo-type photoresist composition comprising contacting said photoresist with the composition of Claim 8, 9 or 10 in an amount sufficient to develop said exposed photoresist.

12. An aqueous developer composition comprising methylbis-(2-hydroxyethyl)cocoammonium chloride and an alkali.

13. The composition of Claim 12 in which the alkali is NaOH.

14. The composition of Claim 12 in which the pH of the composition is about 12.0 to 13.2.

15. The method of developing an exposed positive working diazo-type photoresist comprising contacting said photoresist with the composition of Claim 12, 13 or 14.